# EUROPEAN PATENT APPLICATION

(11) **EP 2 787 646 A1**
(43) Date of publication of application: **08.10.2014**
(21) Application number: 12785708.4
(22) Date of filing: 10.04.2012
(51) Int. Cl.: H03M 7/30, H04W 28/06, H04L 25/03

(54) **METHOD AND DEVICE FOR COMPRESSING IN-PHASE QUADRATURE DATA**

(30) Priority: 08.10.2011 CN 201110299841
(71) Applicant: ZTE Corporation, Shenzhen, Guangdong 518057 (CN)
(72) Inventor: ZHANG, Shuai, Shenzhen, Guangdong 518057 (CN); XIANG, Jiying, Shenzhen, Guangdong 518057 (CN); XU, Jin, Shenzhen, Guangdong 518057 (CN); HU, Liujun, Shenzhen, Guangdong 518057 (CN)
(74) Representative: Brevalex
(86) International application number: PCT/CN2012/073723
(87) International publication number: WO 2012/155718

(57) **Abstract**

An In-phase Quadrature (IQ) data compression method includes determining, by an Evolved Radio Remote Unit, eRRU, according to time-frequency information carried in IQ data from each antenna, whether the IQ data is one of Physical Random Access Channel, PRACH, information and traffic channel data information, which is required to undergo a predefined quantification processing; if it is determined that the IQ data is PRACH information which is required to undergo a predefined quantification processing, performing a 15-bit quantification processing on the PRACH information; and if it is determined that the IQ data is traffic channel data information which is required to undergo a predefined quantification processing, performing a less-than-15-bit quantification processing on the traffic channel data information; and transmitting the data which has undergone the quantification processing to an Evolved Building Baseband Unit, eBBU. An eRRU and eNodeB are also provided. With the embodiments of the disclosure, the optical port rate may be reduced and it may avoid frequently replacing equipments.

## Description

### TECHNICAL FIELD

The disclosure relates to the data compression technology in mobile communications, and in particular to an In-phase / Quadrature (IQ) data compression method and device.

### BACKGROUND

A Long Term Evolution (LTE) wireless communication system generally uses an Evolved NodeB (eNodeB). The eNodeB includes an Evolved Building Baseband Unit (eBBU) and an Evolved Radio Remote Unit (eRRU), which are connected to each other through a fiber or a cable.

The eBBU includes a Radio Equipment Control (REC), the eRRU includes a Radio Equipment (RE), the REC and the RE perform data exchange with each other using a Common Public Radio Interface (CPRI) protocol or an Open Radio Interface (ORI) protocol, and the data transmission rate is referred to as optical port rate.

The CPRI protocol defines that an 8B/10B encoding scheme should be employed at the physical layer. The CPRI protocol supports a series of levels of physical layer rates, such as, 614.4/1228.8/2457.6/3072/4915.2/6144Mbps. The CPRI protocol defines that the period of each basic frame at the data link layer is 1/3.84M(s), i.e., about 260.42ns, and each basic frame contains one byte of control information and 15 bytes of IQ data. In addition, the CPRI protocol also defines that each 256 basic frames form a super frame and each 150 super frames form a radio frame of 10ms.

The formula for calculating the optical port rate can be written as: optical port rate = (bit width of I data + bit width of Q data) * sampling rate * number of antennas * optical port redundancy * control word redundancy (1).

Assuming that the eNodeB of the LTE wireless communication system includes 4 antennas, the bandwidth of the LTE wireless communication system is 20M (corresponding to a sampling rate of 30.72m/s), both the bit widths of the I and Q data are 15bits, the optical port redundancy is 10/8, the control word redundancy is 16/15, where the value of the optical port redundancy depends on the condition of fiber, and the value of the control word redundancy depends on the condition of REC. Thus, the rate of the optical port between the eRRU and the eBBU can be obtained according to formula (1): optical port rate = (15 + 15) * 30.72 * 4 *10/8 * 16/15 = 4.9152Gbps.

In the case of fiber and eNodeB, with the continuous increasing of the bandwidth and the number of antennas of the LTE wireless communication system, the optical port rate will be constantly increased, as known from formula (1). Because of the increasing of the optical port rate, the data flow between the eBBU and the eRRU of the eNodeB will be increased accordingly, then the requirement for the throughput of the eBBU and the eRRU becomes higher and higher, it is necessary to upgrade the eBBU and the eRRU when they could not satisfy the requirement for the throughput, thus leading to the increasing of costs for maintaining the LTE wireless communication system.

### SUMMARY

In view of the above, an IQ data compression method and device is provided, which is capable of reducing the optical port rate and avoiding updating equipments frequently.

The technical solutions according to the embodiment of the disclosure are provided as follows.

In an embodiment of the disclosure, an In-phase Quadrature (IQ) data compression method is provided, which includes: determining, by an Evolved Radio Remote Unit, eRRU, according to time-frequency information carried in IQ data from each antenna, whether the IQ data is one of Physical Random Access Channel, PRACH, information and traffic channel data information, which is required to undergo a predefined quantification processing; if it is determined that the IQ data is PRACH information which is required to undergo a predefined quantification processing, perform a 15-bit quantification processing on the PRACH information; and if it is determined that the IQ data is traffic channel data information which is required to undergo a predefined quantification processing, perform a less-than-15-bit quantification processing on the traffic channel data information; and transmitting the data which has undergone the quantification processing to an Evolved Building Baseband Unit, eBBU.

Preferably, the determining includes: matching, by the eRRU, the index value in the time-frequency information carried in the IQ data from each antenna with preset identification information corresponding to the respective antenna; if the index value matches the preset identification information, determining that the IQ data is one of the PRACH information and the traffic channel data information, which is required to undergo the predefined quantification processing; if the index value does not match the preset identification information, determining that the IQ data is not one of the PRACH information and the traffic channel data information, which is required to undergo the predefined quantification processing.

Preferably, the identification information is classified into: identification information of the PRACH information identical to the index value of the PRACH information, and identification information of the traffic channel data information identical to the index value of the traffic channel data information; accordingly, matching, by the eRRU, the index value in the time-frequency information carried in the IQ data from each antenna with preset identification information corresponding to the respective antenna; if the index value matches the preset identification information of the PRACH information, determine that the IQ data is the PRACH information which is required to undergo the predefined quantification processing; if the index value does not match the preset identification information of the PRACH information, determining that the IQ data is not the PRACH information which is required to undergo the predefined quantification processing; if the index value matches the preset identification information of the traffic channel data information, determine that the IQ data is the traffic channel data information which is required to undergo the predefined quantification processing; if the index value does not match the preset identification information of the traffic channel data information, determine that the IQ data is not the traffic channel data information which is required to undergo the predefined quantification processing.

Preferably, the method may further include: after the eRRU determines, according to time-frequency information carried in IQ data from each antenna, whether the IQ data is one of PRACH information and traffic channel data information, which is required to undergo the predefined quantification processing, discarding the IQ data if it is determined that the IQ data is not the PRACH information or the traffic channel data information which is required to undergo the quantification processing.

Preferably, the performing the less-than-15-bit quantification processing may include: performing a 9-bit quantification processing.

In another embodiment of the disclosure, an eRRU is provided, which includes: a determination module, configured to determine, according to time-frequency information carried in IQ data from each antenna, whether the IQ data is one of Physical Random Access Channel, PRACH, information and traffic channel data information, which is required to undergo a predefined quantification processing; a quantification processing module, configured to perform a 15-bit quantification processing on PRACH information if it is determined that the IQ data is the PRACH information which is required to undergo a predefined quantification processing and to perform a less-than-15-bit quantification processing on the traffic channel data information if it is determined that the IQ data is traffic channel data information which is required to undergo a predefined quantification processing; and a transmission module, configured to transmit the data which has undergone the quantification processing to an Evolved Building Baseband Unit, eBBU.

Preferably, the determination module is configured to match the index value in the time-frequency information carried in the IQ data from each antenna with preset identification information corresponding to the respective antenna; if the index value matches the preset identification information, determine that the IQ data is one of the PRACH information and the traffic channel data information, which is required to undergo the predefined quantification processing; if the index value does not match the preset identification information, determine that the IQ data is not one of the PRACH information and the traffic channel data information, which is required to undergo the predefined quantification processing.

Preferably, the identification information is classified into: identification information of the PRACH information identical to the index value of the PRACH information, and identification information of the traffic channel data information identical to the index value of the traffic channel data information; the determination module is configured to match the index value in the time-frequency information carried in the IQ data from each antenna with preset identification information corresponding to the respective antenna; if the index value matches the preset identification information of the PRACH information, determine that the IQ data is the PRACH information which is required to undergo the predefined quantification processing; if the index value does not match the preset identification information of the PRACH information, determining that the IQ data is not the PRACH information which is required to undergo the predefined quantification processing; if the index value matches the preset identification information of the traffic channel data information, determine that the IQ data is the traffic channel data information which is required to undergo the predefined quantification processing; if the index value does not match the preset identification information of the traffic channel data information, determine that the IQ data is not the traffic channel data information which is required to undergo the predefined quantification processing.

Preferably, the eRRU may further include a discard module, configured to discard the IQ data if it is determined that the IQ data is not the PRACH information or the traffic channel data information which is required to undergo the quantification processing.

Preferably, the quantification processing module is configured to perform a 15-bit quantification processing on the determined PRACH information which is required to undergo the predefined quantification processing, such that the processed data has a bit width of 15 bits, and perform 9-bit quantification processing on the determined traffic channel data information which is required to undergo the predefined quantification processing, such that the processed data has a bit width of 9 bits.

In yet another embodiment of the disclosure, an eNodeB is provided, which includes an eRRU and an eBBU, wherein the eRRU is configured to determine, according to time-frequency information carried in IQ data from each antenna, whether the IQ data is one of Physical Random Access Channel, PRACH, information and traffic channel data information, which is required to undergo a predefined quantification processing; if it is determined that the IQ data is PRACH information which is required to undergo a predefined quantification processing, perform a 15-bit quantification processing on the PRACH information; and if it is determined that the IQ data is traffic channel data information which is required to undergo a predefined quantification processing, perform a less-than-15-bit quantification processing on the traffic channel data information; and transmit the data which has undergone the quantification processing to the eBBU, and the eBBU is configured to receive the data from the eRRU.

It is known from the above description that, with the IQ data compression method provided in the embodiment of the disclosure, the bit width of the traffic channel data information is compressed to less than 15 bits during the quantification processing of the traffic channel data information in the IQ data, which makes the bit width of the IQ data to be reduced, therefore reducing the optical port rate and avoiding updating equipments frequently.

### BRIEF DESCRIPTION OF THE DRAWINGS

Fig. 1 is a flowchart of an IQ data compression method according to an embodiment of the disclosure; and
Fig. 2 is a block diagram of the eRRU according to an embodiment of the disclosure.

### DETAILED DESCRIPTION

According to various embodiments of the disclosure, en eRRU determines, according to time-frequency information carried in IQ data from each antenna, whether the IQ data is one of Physical Random Access Channel, PRACH, information and traffic channel data information, which is required to undergo a predefined quantification processing; if it is determined that the IQ data is PRACH information which is required to undergo a predefined quantification processing, performs a 15-bit quantification processing on the PRACH information; and if it is determined that the IQ data is traffic channel data information which is required to undergo a predefined quantification processing, performs a less-than-15-bit quantification processing on the traffic channel data information; and then transmits the data which has undergone the quantification processing to the eBBU.

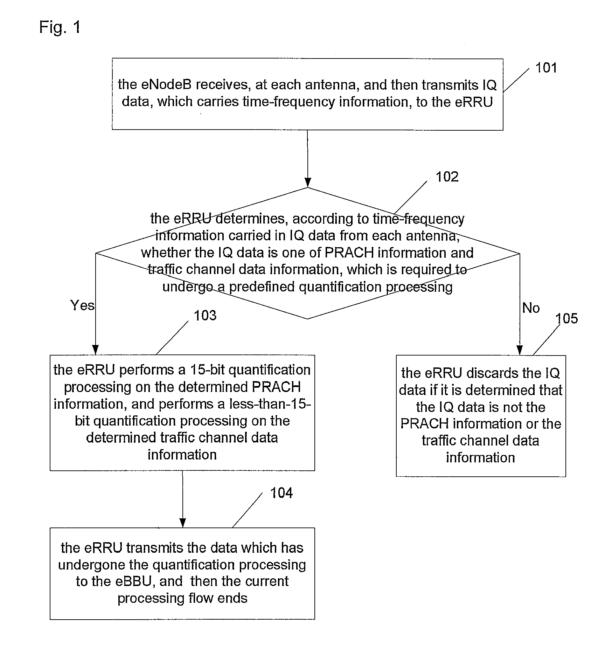

In an embodiment of the disclosure, an In-phase Quadrature (IQ) data compression method is provided. As shown in Fig. 1, the method includes the following steps.

Step 101, the eNodeB receives, at each antenna, and then transmits IQ data to the eRRU. The IQ data carries time-frequency information.

The IQ data may include PRACH information and traffic channel data information, both of them carrying time-frequency information which may be different from each other.

Specifically, the time-frequency information includes frequency domain parameters and time domain parameters. The frequency domain parameters include a resource block index value, the time domain parameters include a subframe index value. The resource block index value is identical to the subframe index value. The index value of the PRACH information is different from that of data information of the traffic channel. Said index values include a resource block index value and a subframe index value. For example, both of the resource block index value and the subframe index value of the PRACH information are 1, while the resource block index value and the subframe index value of the data information of the traffic channel can be any integer between 2 and 100.

Step 102, the eRRU determines, according to time-frequency information carried in IQ data from each antenna, whether the IQ data is one of Physical Random Access Channel, PRACH, information and traffic channel data information, which is required to undergo a predefined quantification processing; if yes, executes step 103; if not, executes step 105.

Specifically, the eRRU matches the index value in the time-frequency information carried in the IQ data from each antenna with preset identification information corresponding to the respective antenna; if the index value matches the preset identification information, determines that the IQ data is one of the PRACH information and the traffic channel data information, which is required to undergo the predefined quantification processing; if the index value does not match the preset identification information, determines that the IQ data is not one of the PRACH information and the traffic channel data information, which is required to undergo the predefined quantification processing.

Further, the identification information is classified into: identification information of the PRACH information identical to the index value of the PRACH information, and identification information of the traffic channel data information identical to the index value of the traffic channel data information; the identification information may be the index value of the PARCH information or the index value of the traffic channel data information.

If the index value matches the preset identification information of the PRACH information, it is determined that the IQ data is the PRACH information which is required to undergo the predefined quantification processing. If the index value does not match the preset identification information of the PRACH information, it is determined that the IQ data is not the PRACH information which is required to undergo the predefined quantification processing.

If the index value matches the preset identification information of the traffic channel data information, it is determined that the IQ data is the traffic channel data information which is required to undergo the predefined quantification processing. If the index value does not match the preset identification information of the traffic channel data information, it is determined that the IQ data is not the traffic channel data information which is required to undergo the predefined quantification processing.

Assuming that the eNodeB has 8 antennas in total, 8 pieces of identification information are set in the eRRU, each piece of identification information corresponds to a respective antenna. For example, the identification information of antennas 1 to 3 is set to 1, that is, the identification information is the identification information of the PRACH information; the identification information of antennas 4 to 8 is set in a range of 2 to 100, that is, the identification information is the identification information of the traffic channel data information. When the index value of the time-frequency information carried in the IQ data from the first antenna matches the identification information corresponding to the first antenna, which means that the index value is 1, it is determined that the IQ data is the PRACH information which is required to undergo the predefined quantification processing; When the index value of the time-frequency information carried in the IQ data from the second antenna matches the identification information corresponding to the second antenna, which means that the index value is not 1, it is determined that the IQ data is not the PRACH information which is required to undergo the predefined quantification processing.

Likewise, when the index value of the time-frequency information carried in the IQ data from the fourth antenna matches the identification information corresponding to the fourth antenna, which means that the index value is any integer between 2 and 100, it is determined that the IQ data is the traffic channel data information which is required to undergo the predefined quantification processing; when the index value of the time-frequency information carried in the IQ data from the eighth antenna matches the identification information corresponding to the eighth antenna, which means that the index value is not any integer between 2 and 100, it is determined that the IQ data is not the traffic channel data information which is required to undergo the predefined quantification processing.

In this way, the eRRU can determine whether the IQ data from antennas 1 to 3 is the PRACH information which is required to undergo the predefined quantification processing. Likewise, the eRRU can determine whether the IQ data from antennas 4 to 8 is the traffic channel data information which is required to undergo the predefined quantification processing. Step 103 is executed when the IQ data from antennas 1 to 3 is the PRACH information, and step 105 is executed when the IQ data from the antennas 1 to 3 is not the PRACH information. Likewise, Step 103 is executed when the IQ data from antennas 4 to 8 is the traffic channel data information, and step 105 is executed when the IQ data from the antennas 4 to 8 is not the traffic channel data information.

Of course, identification information corresponding to each antenna may be modified according to the practice. For example, the identification information corresponding to the fourth antenna can be set to 1, and thus the eRRU will determine whether the IQ data from the fourth antenna is the PRACH information according to the identification information, but will not determine whether the IQ data from the fourth antenna is the traffic channel data information, which enables the eRRU to determine whether the IQ data is the PRACH information which is required to undergo the predefined quantification processing.

Step 103, the eRRU performs a 15-bit quantification processing on the determined PRACH information which is required to undergo the predefined quantification processing, such that the processed data has a bit width of 15 bits, and performs a less-than-15-bit quantification processing on the determined traffic channel data information which is required to undergo the predefined quantification processing, such that the processed data has a bit width of less than 15 bits.

Specifically, the number of bits obtained after the quantification processing may correspond to the identification information. Identification information set as "1" corresponding to 15 bits, and identification information set as a range of 2 to 100 corresponds to a number of less than 15 bits, for example, any of 5, 6, 7, 8, 9, 10, 11, 12, 13 or 14 and preferably, 9. This is because, if a more-than-10-bit quantification processing is performed, the bit width of the processed data is still too large and the effect of data compression is not significant. However, if a less-than-8-bit quantification processing is performed, the bit width of the processed data is too small, and the data is over compressed, leading to severe distortion of the data. Therefore, a 9-bit-quantification processing is employed, which can result in processed data with a proper bit width, implement effective compression of the data and avoid sever distortion of data due to the compression.

Assuming that the index value of the time-frequency information carried in the IQ data from antennas 1 and 2 is 1, a 15-bit quantification processing is performed on the IQ data, i.e, the PARCH information, making the processed data to have a bit width of 15 bits. If the index value of the time-frequency information carried in the IQ data from antennas 4 and 6 is 100, a 9-bit quantification processing is performed on the IQ data, i.e, the traffic channel data information, making the processed data to have a bit width of 9 bits.

Step 104, the eRRU transmits the data which has undergone the quantification processing to the eBBU, and then the current processing flow ends.

Step 105, the eRRU discards the IQ data if it is determined that the IQ data is not the PRACH information or the traffic channel data information which is required to undergo the quantification processing, and then the current processing flow ends.

Assuming that the index value of the time-frequency information carried in the IQ data from the third antenna is 2, the eRRU discards the traffic channel data information. If the index value of the time-frequency information carried in the IQ data from antennas 7, 8 is 1, the eRRU discards the PRACH information.

The IQ data is the data information containing the PRACH information and the traffic channel data information, where the PRACH information is an important piece of information and only takes a small portion of the IQ data. In order to avoid loss of excessive PRACH information during the quantification processing which can affect the common operation of the system, a 15-bit quantification processing is performed on the PRACH information, which makes the processed data to have a bit width of 15 bits.

A majority of the IQ data is traffic channel data information, i.e., common data information, which contains Physical Downlink Shared Channel (PUSCH) information and Multiple Channel (MCH) information. Even if many pieces of traffic channel data information are lost during the quantification processing, the normal utilization of the traffic channel data information will not be affected. Thus, a less-than-15-bit quantification processing is performed on the traffic channel data information, making the processed data to have a bit width of less than 15 bits, for example, 9 bits.

It is known from formula (1) that, when the bit width of the majority of the data in the IQ data is reduced, the optical port rate is reduced. Thus, the IQ data compression method provided in the embodiment of the disclosure can reduce the optical port rate by reducing the bit width of the IQ data, so as to avoid updating devices frequently.

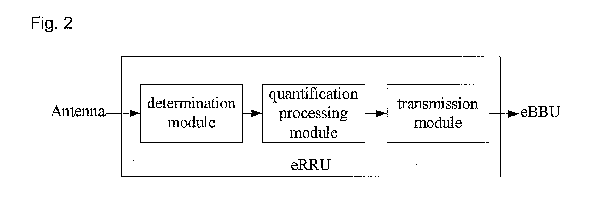

In an embodiment of the disclosure, an eRRU is provided, as shown in Fig. 2, which includes a determination module, a quantification processing module and a transmission module.

The determination module is configured to determine, according to time-frequency information carried in IQ data from each antenna, whether the IQ data is one of Physical Random Access Channel, PRACH, information and traffic channel data information, which is required to undergo a predefined quantification processing.

The quantification processing module is configured to perform a 15-bit quantification processing on the determined PRACH information which is required to undergo the predefined quantification processing, such that the processed data has a bit width of 15 bits, and perform a less-than-15-bit quantification processing on the determined traffic channel data information which is required to undergo the predefined quantification processing, such that the processed data has a bit width of less than 15 bits.

The transmission module is configured to transmit the data which has undergone the quantification processing to an eBBU.

Specifically, the determination module may be configured to match the index value in the time-frequency information carried in the IQ data from each antenna with preset identification information corresponding to the respective antenna; if the index value matches the preset identification information, determining that the IQ data is one of the PRACH information and the traffic channel data information, which is required to undergo the predefined quantification processing; if the index value does not match the preset identification information, determining that the IQ data is not one of the PRACH information and the traffic channel data information, which is required to undergo the predefined quantification processing.

Specifically, the identification information may be classified into: identification information of the PRACH information identical to the index value of the PRACH information, and identification information of the traffic channel data information identical to the index value of the traffic channel data information.

Accordingly, the determination module may be configured to match the index value in the time-frequency information carried in the IQ data from each antenna with preset identification information corresponding to the respective antenna; if the index value matches the preset identification information of the PRACH information, determine that the IQ data is the PRACH information which is required to undergo the predefined quantification processing; if the index value does not match the preset identification information of the PRACH information, determine that the IQ data is not the PRACH information which is required to undergo the predefined quantification processing; if the index value matches the preset identification information of the traffic channel data information, determine that the IQ data is the traffic channel data information which is required to undergo the predefined quantification processing; if the index value does not match the preset identification information of the traffic channel data information, determine that the IQ data is not the traffic channel data information which is required to undergo the predefined quantification processing.

The eRRU may further include a discard module, configured to discard the IQ data if it is determined that the IQ data is not the PRACH information or the traffic channel data information which is required to undergo the quantification processing.

Accordingly, the quantification processing module may be configured toperform a 15-bit quantification processing on the PRACH information, if it is determined that the IQ data is PRACH information which is required to undergo predefined quantification processing; and perform a less-than-15-bit quantification processing on the data information of the traffic channel, preferably, a 9-bit quantification procession, if it is determined that the IQ data is data information of the traffic channel which is required to undergo predefined quantification processing.

In yet another embodiment of the disclosure, an eNodeB is provided, which includes an eRRU and an eBBU. The eRRU is configured to determine, according to time-frequency information carried in IQ data from each antenna, whether the IQ data is one of Physical Random Access Channel, PRACH, information and traffic channel data information, which is required to undergo a predefined quantification processing; perform a 15-bit quantification processing on the determined PRACH information which is required to undergo the predefined quantification processing, such that the processed data has a bit width of 15 bits, and perform a less-than-15-bit quantification processing on the determined traffic channel data information which is required to undergo the predefined quantification processing, such that the processed data has a bit width of less than 15 bits. transmit the data which has undergone the quantification processing to the eBBU, and the eBBU is configured to receive the data from the eRRU.

The description above is only the preferable embodiment of the disclosure, and is not to limit the scope of the disclosure.

## Claims

1. A method for In-phase / Quadrature, IQ, data compression, comprising:
determining, by an Evolved Radio Remote Unit, eRRU, according to time-frequency information carried in IQ data from each antenna, whether the IQ data is one of Physical Random Access Channel, PRACH, information and traffic channel data information, which is required to undergo a predefined quantification processing;
if it is determined that the IQ data is PRACH information which is required to undergo the predefined quantification processing, performing a 15-bit quantification processing on the PRACH information; and if it is determined that the IQ data is traffic channel data information which is required to undergo the predefined quantification processing, performing a less-than-15-bit quantification processing on the traffic channel data information; and
transmitting the data which has undergone the quantification processing to an Evolved Building Baseband Unit, eBBU.

2. The method according to claim 1, wherein the determining comprises:
matching, by the eRRU, an index value in the time-frequency information carried in the IQ data from each antenna with preset identification information corresponding to the respective antenna;
if the index value matches the preset identification information, determining that the IQ data is one of the PRACH information and the traffic channel data information, which is required to undergo the predefined quantification processing; and
if the index value does not match the preset identification information, determining that the IQ data is not one of the PRACH information and the traffic channel data information, which is required to undergo the predefined quantification processing.

3. The method according to claim 2, wherein the identification information is classified into: identification information of the PRACH information identical to the index value of the PRACH information, and identification information of the traffic channel data information identical to the index value of the traffic channel data information;
accordingly, matching, by the eRRU, the index value in the time-frequency information carried in the IQ data from each antenna with preset identification information corresponding to the respective antenna;
if the index value matches the preset identification information of the PRACH information, determining that the IQ data is the PRACH information which is required to undergo the predefined quantification processing;
if the index value does not match the preset identification information of the PRACH information, determining that the IQ data is not the PRACH information which is required to undergo the predefined quantification processing;
if the index value matches the preset identification information of the traffic channel data information, determining that the IQ data is the traffic channel data information which is required to undergo the predefined quantification processing;
if the index value does not match the preset identification information of the traffic channel data information, determining that the IQ data is not the traffic channel data information which is required to undergo the predefined quantification processing.

4. The method according to claim 1, 2 or 3, further comprising: after the eRRU determines, according to time-frequency information carried in IQ data from each antenna, whether the IQ data is one of PRACH information and traffic channel data information, which is required to undergo the predefined quantification processing,
if it is determined that the IQ data is not the PRACH information or the traffic channel data information which is required to undergo the quantification processing, discarding the IQ data.

5. The method according to claim 1, 2 or 3, wherein the performing the less-than-15-bit quantification processing comprises: performing a 9-bit quantification processing.

6. An Evolved Radio Remote Unit, eRRU, comprising:
a determination module, configured to determine, according to time-frequency information carried in IQ data from each antenna, whether the IQ data is one of Physical Random Access Channel, PRACH, information and traffic channel data information, which is required to undergo a predefined quantification processing;
a quantification processing module, configured to perform a 15-bit quantification processing on PRACH information if it is determined that the IQ data is the PRACH information which is required to undergo a predefined quantification processing and to perform a less-than-15-bit quantification processing on the traffic channel data information if it is determined that the IQ data is traffic channel data information which is required to undergo a predefined quantification processing; and
a transmission module, configured to transmit the data which has undergone the quantification processing to an Evolved Building Baseband Unit, eBBU.

7. The eRRU according to claim 6, wherein the determination module is configured to:
match the index value in the time-frequency information carried in the IQ data from each antenna with preset identification information corresponding to the respective antenna;
if the index value matches the preset identification information, determine that the IQ data is one of the PRACH information and the traffic channel data information, which is required to undergo the predefined quantification processing; and
if the index value does not match the preset identification information, determine that the IQ data is not one of the PRACH information and the traffic channel data information, which is required to undergo the predefined quantification processing.

8. The eRRU according to claim 6, wherein the identification information is classified into identification information of the PRACH information identical to the index value of the PRACH information, and identification information of the traffic channel data information identical to the index value of the traffic channel data information;
the determination module is configured to:
match the index value in the time-frequency information carried in the IQ data from each antenna with preset identification information corresponding to the respective antenna;
if the index value matches the preset identification information of the PRACH information, determine that the IQ data is the PRACH information which is required to undergo the predefined quantification processing;
if the index value does not match the preset identification information of the PRACH information, determining that the IQ data is not the PRACH information which is required to undergo the predefined quantification processing;
if the index value matches the preset identification information of the traffic channel data information, determine that the IQ data is the traffic channel data information which is required to undergo the predefined quantification processing; and
if the index value does not match the preset identification information of the traffic channel data information, determine that the IQ data is not the traffic channel data information which is required to undergo the predefined quantification processing.

9. The eRRU according to claims 6, 7 or 8, further comprising:
a discard module, configured to discard the IQ data if it is determined that the IQ data is not the PRACH information or the traffic channel data information which is required to undergo the quantification processing.

10. The eRRU according to claim 9, wherein the quantification processing module is configured to:
perform a 15-bit quantification processing on the determined PRACH information which is required to undergo the predefined quantification processing, such that the processed data has a bit width of 15 bits; and
perform a 9-bit quantification processing on the determined traffic channel data information which is required to undergo the predefined quantification processing, such that the processed data has a bit width of 9 bits.

11. An eNodeB, comprising an Evolved Radio Remote Unit, eRRU, and an Evolved Building Baseband Unit, eBBU,
wherein the eRRU is configured to:
determine, according to time-frequency information carried in IQ data from each antenna, whether the IQ data is one of Physical Random Access Channel, PRACH, information and traffic channel data information, which is required to undergo a predefined quantification processing;
perform a 15-bit quantification processing on the PRACH information if it is determined that the IQ data is PRACH information which is required to undergo a predefined quantification processing;
perform a less-than-15-bit quantification processing on the traffic channel data information if it is determined that the IQ data is traffic channel data information which is required to undergo a predefined quantification processing; and
transmit the data which has undergone the quantification processing to the eBBU,and
wherein the eBBU is configured to receive the data from the eRRU.
